# EUROPÄISCHE PATENTSCHRIFT

(11) **EP 1 206 780 B1**
(45) Veröffentlichungstag und Bekanntmachung des Hinweises auf die Patenterteilung: **28.03.2007**
(21) Anmeldenummer: 00958330.3
(22) Anmeldetag: 31.07.2000
(51) Int. Cl.: H01B 13/06, H01F 41/12, H01F 41/00, H02K 15/12, B29C 35/08

(54) **VERFAHREN UND VORRICHTUNG ZUR ISOLIERUNG ELEKTROTECHNISCHER BAUTEILE**
METHOD AND DEVICE FOR INSULATING ELECTRO-TECHNICAL COMPONENTS
PROCEDE ET DISPOSITIF POUR L'ISOLATION DE COMPOSANTS ELECTROTECHNIQUES

(30) Priorität: 21.08.1999 DE 19939760
(43) Veröffentlichungstag der Anmeldung: 22.05.2002
(73) Patentinhaber: Altana Electrical Insulation GmbH, 46483 Wesel (DE)
(72) Erfinder: BLUM, Rainer, D-67069 Ludwigshafen (DE); EICHHORST, Manfred, D-22113 Oststeinbek (DE); HEGEMANN, Günther, D-22301 Hamburg (DE); LIENERT, Klaus-Wilhelm, D-22763 Hamburg (DE)
(74) Vertreter: Fitzner, Uwe
(86) Internationale Anmeldenummer: PCT/EP2000/007380
(87) Internationale Veröffentlichungsnummer: WO 2001/015179

(56) Entgegenhaltungen:
- EP-A- 0 065 147
- WO-A-99/67794
- DE-A- 19 648 133

## Beschreibung

Die vorliegende Erfindung betrifft ein Verfahren zur Isolierung elektrotechnischer Bauteile, bei welchem eine Schicht aus polymerisierbarem Gieß- und Tränkmittel und/oder Lack in fließfähiger Form auf die Oberfläche der Bauteile aufgebracht und anschließend mit Hilfe von energiereicher Strahlung ausgehärtet wird.

Zur elektrischen Isolierung, zur mechanischen Stabilisierung und zur Wärmeverteilung in elektrotechnischen Bauteilen werden bis auf wenige Sonderfälle sogenannte Gieß- und Tränkmittel (GTM) eingesetzt. Dabei handelt es sich in der Regel um flüssige oder durch Wärme verflüssigbare Harze, die durch Wärme und/oder UV-Licht gehärtet (polymerisiert) werden können.

Zur Erzielung schneller Taktzeiten bei der Isolierung von Bauteilen mit den genannten Mitteln setzen sich zunehmend Verfahren durch, bei denen durch Anlegen von Strom an die Wicklungen der Bauteile sehr schnell Wärme erzeugt wird und die GTM gehärtet werden. Problematisch ist dabei allerdings die Härtung an Stellen, die durch den Wärmefluß aus der Wicklung nur unzureichend erhitzt und somit nur unzureichend gehärtet werden können.

Für diese Fälle gewinnen Verfahren an Bedeutung, bei denen zusätzlich zur Wärme UV-Licht zur Härtung der Stellen der Bauteile eingesetzt wird, die durch den Wärmefluß aus den Wicklungen nur unzureichend oder zu langsam erhitzt werden. Ökonomische Probleme ergeben sich dabei aus der Notwendigkeit, die GTM durch chemische Modifikation UV-empfindlich einzustellen, und aus der erforderlichen Mitverwendung teurer Fotoinitiatoren. Darüber hinaus besteht ein technisches Problem in der örtlichen UV-Inhibierung durch Hilfsstoffe, die beim Zusammenbau der Bauteile verwendet werden oder die in Bauteilkomponenten (z.B. den Isolierungen unterschiedlicher Anschlußkabel) vorhanden sind. Hierdurch kann es örtlich zu klebenden Oberflächen kommen.

In der DE-A-40 22 235 und der DD-A-295 056 wird vorgeschlagen, zur Reduktion der Abdampfverluste üblicher Tränkmittel mit hohen Anteilen an Monomeren wie Styrol zunächst mit UV-Strahlen die Oberflächen und dann durch Wärmezufuhr das Innere der Bauteile zu härten.

Weiterhin ist aus der EP-A-0 643 467 bekannt, übliche Tränkmittel mit hohem Anteil an Monomeren wie Styrol zu verwenden und zur Verbesserung der Tränkmittelverteilung im Bauteil schon während der Tränkung über Spulenheizung eine Vorgelierung und Fixierung des Tränkmittels und eine thermische Härtung zu erhalten. Schon gleichzeitig mit der thermischen Härtung auf den Wicklungen oder aber nach der thermischen Härtung auf den Wicklungen sollen solche Stellen der Bauteile, die durch die Wicklungsheizung nicht erreicht wurden, mit energiereicher Strahlung gehärtet werden, vorzugsweise mit UV-Strahlung.

Die DE-A-196 00 149 beschreibt spezielle GTM, die ohne Monomeren härtbar sind. Als Härtungsmittel werden Wärme und/oder aktinische Strahlung in Form von UV-Licht genannt.

Auch in der DE 196 48 132 A1, DE 196 48 133 A1 und DE 196 48 134 A1 werden verschiedene vorteilhafte Kombinationen von GTM mit der Härtung durch Wärme und/oder aktinische Strahlung in Form von UV-Licht beschrieben.

Die EP 0 065 147 offenbart die Beschichtung von elektrotechnischen Bauteilen, wobei NIR-Strahlung jedoch ausschließlich dazu verwendet wird, die Beschichtungen zu gelieren, nicht jedoch zur Aushärtung.

Die Dokumente US 4,234,624 und US 5,705,232 offenbaren die Härtung von Beschichtungenmittels NIR, jedoch betrifft die US 4,234,624 ausschließlich die Beschichtung von Leitern per Extrusion und die US 5,705,232 die Beschichtung von Halbleiterwerkstücken.

Aufgabe der vorliegenden Erfindung war es, ein kostengünstigeres Verfahren zur Isolierung elektrotechnischer Bauteile zur Verfügung zu stellen, welches darüber hinaus keiner Inhibierung durch vom Bauteil stammende chemische Komponenten unterliegt.

Diese Aufgabe wird durch ein Verfahren zur Isolierung elektrotechnischer Bauteile gelöst, bei welchem in bekannter Weise eine Schicht aus polymerisierbarem Gieß- und Tränkmittel und/oder Lack in fließfähiger Form auf die Oberfläche der Bauteile aufgebracht und anschließend mit energiereicher Strahlung ausgehärtet wird.

Die mit dem Verfahren isolierbaren Bauteilen sind u.a. Transformatoren oder andere Bauteile mit Wicklungen sowie Leitungsdrähte. Während bei komplizierter geformten Bauteilen eine Tränkung zur vollständigen Benetzung der zu isolierenden Oberflächen erforderlich ist, reicht bei elektrischen Leitungsdrähten im allgemeinen eine Lackierung.

Durch die Anwendung von NIR-Strahlung ist es möglich, in allen Fällen, bei denen bisher UV-Härtung eingesetzt wird, nunmehr konventionelle rein thermisch härtbare GTM einzusetzen. Dies bedeutet eine erhebliche Kostenreduktion. Weiterhin sind keine UV-Inhibierungen zu beachten, und die Stoffe können ohne die Gefahr der vorzeitigen Polymerisation unter Tageslicht hantiert werden. Darüber hinaus kann auch eine Kombination von konventioneller Erwärmung, z.B. mit Umluft, Stromwärme und IR-Strahlung (mit einer typischen Wellenlänge von bis zu 10⁶ nm), mit der erfindungsgemäßen Erwärmung mit NIR-Strahlung und mit zusätzlicher Härtung durch UV-Licht für spezielle Zwecke sinnvoll sein. Die Auswahl einer sinnvollen Kombination ist dem Fachmann im Einzelfall anhand technischer und ökonomischer Überlegungen möglich.

Der Vorteil der NIR-Strahlung im Vergleich zu mittel- und langwelligen IR-Strahlung liegt darin, daß sie bei den zu härtenden Harzmassen direkt in die bei Elektroisolierstoffen übliche Schichtdicke eindringt, während langwellige IR-Strahlung an der Oberfläche absorbiert wird und die Erwärmung der tieferliegenden Bereiche nur durch Wärmefluß möglich ist, wofür lange Heizzeiten benötigt werden und die Gefahr der Überhitzung an der Oberfläche besteht.

Ein weiterer Vorteil des erfindungsgemäßen Verfahrens besteht darin, daß es auf vorhandenen, nur durch Nachschaltung einer NIR-Lampe geringfügig modifizierten Anlagen durchgeführt werden kann. Eine Anpassungen der Anlage ist dabei im wesentlichen bereits durch Änderung der Steuerungsparameter und der Verfahrensreihenfolge möglich.

Ein anderer wesentlicher Vorteil der Erfindung ist neben den ökonomischen Gründen, die in der Einsparung der Fotoinitiatoren, einem einfacheren Aufbau der Harze und einer kürzeren Taktzeit bestehen, die Möglichkeit, auch temperatursensitive Bereiche der Bauteile ohne Schädigung sehr schnell zu härten, weil die NIR-Strahlung die Harzschichten sehr schnell auf hohe Temperatur erwärmt und die Härtung abgeschlossen ist, bevor die darunterliegenden Bereiche zu heiß werden.

Die erfindungsgemäß eingesetzte NIR-Strahlung hat eine Wellenlänge von 500 nm bis 1400 nm, bevorzugt von 750 nm bis 1100 nm. NIR-Strahlung in diesen Wellenlängenbereichen läßt sich einerseits verhältnismäßig einfach und gut steuerbar erzeugen, andererseits deckt sie den für die Aushärtung der GTM bzw. Lacke optimalen Bereich ab.

Um ein Eindringen der NIR-Strahlung in die Harzmassen bzw. Lackschichten zu ermöglichen, liegt das Intensitätsmaximum der NIR-Quellen vorteilhafterweise in einem Wellenlängenbereich, bei dem das Gieß- und Tränkmittel bzw. der Drahtlack teilweise für das NIR-Licht transparent ist, d.h., daß sein Absorptionsgrad bei dieser Wellenlänge zwischen 20 und 80%, bevorzugt 40 und 70%, liegt.

Weiter ist es vorteilhaft, die NIR-Strahlung mit optischen Einrichtungen so zu fokussieren und zu lenken, daß auf den zu härtenden Bauteilen bzw. Drähten eine der Härtungscharakteristik der Stoffe angepaßte Temperaturverteilung erreicht wird. Das Vorliegen einer solchen Verteilung kann dabei mit Hilfe geeigneter Meßeinrichtungen oder durch Modellrechnungen überprüft werden.

Im Rahmen des erfindungsgemäßen Verfahrens kann die Beschichtung zusätzlich durch eine thermische Erwärmung mit erhitzten Gasen (Umluft), durch UV-Licht und/oder durch Elektronenstrahlung gehärtet werden. Durch den zusätzlichen Einsatz von NIR-Strahlung ist es dann möglich, den Erwärmungsverlauf gezielter zu steuern.

Zu tränkende Bauteile werden vorzugsweise bei Umgebungstemperatur oder im vorerwärmtem Zustand getränkt oder beim Tränken erwärmt. Hierdurch werden die GTM flüssiger und können daher besser in enge Räume der Bauteile eindringen.

Weiterhin werden getränkte Bauteile nach dem Tränken und vor dem Härten vorzugsweise bis zum Angelieren erwärmt. Dabei kann die Menge des gelierten Tränkmittels durch Tempo, Höhe und Dauer der Erwärmung gesteuert werden. Durch das Angelieren verfestigen sich die aufgebrachten Beschichtungsmittel so weit, daß sie bei der nachfolgenden Bearbeitung nicht wieder einfach vom Bauteil abfließen und dabei ungeschützte Bereiche hinterlassen. Die Erwärmung kann bei Bauteilen mit einer Wicklung durch den Fluß elektrischen Stromes durch die Wicklung erfolgen.

Die Tränkung der Bauteile kann durch Tauchen, Fluten, Vakuumtränken, Vakuumdrucktränken oder Träufeln erfolgen.

Bei Bauteilen mit elektrisch leitenden Wicklungen werden vorteilhafterweise die Wicklungen der durchgetränkten Bauteile im Tränkmittel durch Anlegen von Strom soweit erhitzt, daß eine gewünschte Tränkmittelmenge geliert und fixiert wird, wobei nach dieser Gelierung das Bauteil aus dem Tränkmittel entnommen wird, ungeliertes Tränkmittel abläuft und gegebenenfalls gekühlt und zurückgeführt wird, und die Bauteile danach gehärtet werden. Der geschilderte Verfahrensablauf hat sich für Bauteile mit Wicklungen wie z.B. Transformatoren als besonders günstig erwiesen.

Für das Verfahren geeignete GTM sind beispielsweise in der DE-A-195 42 564, DE-A-196 00 149, DE-A-197 57 227 und DE 196 48 133 A1 beschrieben. Dabei ist es, wenn nicht eine zusätzlich UV-Härtung gewünscht wird, ökonomisch und technisch sinnvoll, auf die Verwendung von Fotoinitiatoren zu verzichten.

Stoffe, mit denen das erfindungsgemäße Verfahren durchgeführt werden kann, sind insbesondere die allgemein bekannten Tränkmittel auf Basis ungesättigter Polyesterharze, die durch Zubereitung mit ungesättigten Monomeren als Reaktiwerdünner radikalisch copolymerisierbar werden. Zweckmäßig auszuwählenden Polyester sind dem Fachmann bekannt, ebenso imid- oder amidmodifizierte Polyester, die besonders günstige thermische und mechanische Eigenschaften aufweisen. Auch die zweckmäßig auszuwählenden Reaktiwerdünner sind bekannt; es sind insbesondere Styrol, alpha-Methylstyrol, Vinyltoluol, Allylester, Vinylester, Vinylether und/oder (Meth-)acrylate.

Weitere Stoffe, mit denen das erfindungsgemäße Verfahren durchgeführt werden kann, sind radikalisch polymerisierbare monomere, oligomere und/oder polymere Stoffe, die auch strahlenhärtbar sind. Auch diese Stoffe und Stoffkombinationen sind dem Fachmann allgemein bekannt. Es handelt sich besonders um allylisch, vinylisch oder (meth-)acrylisch ungesättigte Stoffe und/oder Stoffgemische. Gut geeignet sind z.B. Polyepoxy-(meth-)acrylate, Polyurethan-(meth-)acrylate und/oder Polyester-(meth-)acrylate.

Die Zubereitungen sind z.T. direkt thermisch polymerisierbar, für eine optimale thermische Härtung bei möglichst niedrigen Temperaturen ist es aber bevorzugt und zweckmäßig, Radikalstarter zuzusetzen. Weiterhin werden in der Regel für eine schnelle UV-Härtung UV-Initiatoren zugesetzt. Auch die Mitverwendung von Stabilisatoren zur Verbesserung der Lagerstabilität ist bekannter Stand der Technik.

Femer können auch ionisch polymerisierbare Stoffe eingesetzt werden, das sind besonders monomere und/oder oligomere Epoxyde in Verbindung mit thermisch und unter UV-Licht aktivierbaren Initiatoren. Auch solche Stoffe sind bekannter Stand der Technik.

Besonders vorteilhaft ist das erfindungsgemäße Verfahren in Kombination mit den monomerenfrei härtbaren Stoffen laut DE 195 42 564, DE 196 00 149, DE 197 57 227 und DE 196 48 133 A1, weil diese bei der Härtung nicht leicht entzündlich sind. Aber auch die Härtung von üblichen GTM mit hohen Anteilen an Monomeren wie Styrol, Acrylestern u.ä. mit NIR ist möglich und technisch durchführbar, wenn z.B. durch Reduktion der Leistung und/oder Taktung der NIR-Strahler dafür gesorgt wird, daß die Zündtemperatur der GTM, die weit über der Härtungstemperatur liegt, nicht überschritten wird. Weiter ist es möglich, durch örtliche Zufuhr von Inertgas oder Frischluft dafür zu sorgen, daß keine zünd- oder explosionsfähigen Gasgemische entstehen.

Weiterhin wird eine Vorrichtung zur Isolierung elektrotechnischer Bauteile eingesetzt, wobei die Vorrichtung eine Beschichtungseinrichtung zur Aufbringung einer Schicht aus polymerisierbarem Gieß- und Tränkmittel und/oder Lack auf die Oberfläche der Bauteile und eine Heizvorrichtung zur Erwärmung der Bauteile aufweist. Die Heizvorrichtung enthält mindestens eine Nah-Infra-Rot (NIR) Strahlungsquelle. Mit der Vorrichtung läßt sich somit das oben erläuterte erfindungsgemäße Verfahren durchführen, wobei sich die erläuterten Vorteile einstellen.

Als NIR-Strahlungsquellen kommen kommerziell erhältliche Strahler in Frage, die mit hohem Anteil ihrer Strahlung in dem bevorzugten Wellenlängenbereich emittieren. Meist handelt es sich dabei um Halogenstrahler mit hoher Glühwendeltemperatur (z.B. Halogenstrahler von USHIO Inc., Tokyo). Der Vorteil der NIR-Strahlung im Vergleich zu mittel- und langwelligen IR-Strahlern liegt in der sehr schnellen Regelbarkeit der Strahlungsintensität, ohne daß sich dabei das Emissionsmaximum aus dem Bereich der NIR-Wellenlänge entfernt. Weiterhin dringen die NIR-Strahlen in die zu härtenden Harzmassen direkt in die bei Elektroisolierstoffen übliche Schichtdicke ein, während langwellige IR-Strahlung an der Oberfläche absorbiert wird und die Erwärmung der tieferliegenden Bereiche nur durch Wärmefluß möglich ist, wofür lange Heizzeiten benötigt werden und die Gefahr der Überhitzung an der Oberfläche besteht.

Die Heizvorrichtung enthält vorzugsweise eine elektrische Regelung der NIR-Strahlungsquellen, um die auf die Objekte einwirkende Strahlungsenergie und/oder Wellenlänge einzustellen. Weiterhin kann die Vorrichtung optische Filtereinrichtungen enthalten, um die auf die Objekte einwirkende Strahlungsenergie und/oder Wellenlänge einzustellen.

### Beispiele

Im folgenden wird die Erfindung mit Hilfe von Versuchsbeispielen erläutert.

Die Versuche wurden in einer Laboranlage durchgeführt. Die Anlage hat einen oben offenen Behälter als Vorlage für die GTM, der mit einem Deckel, der auch als Abtropfblech dient, verschlossen werden kann. Über dem Behälter ist eine Halterung für die zu tränkenden Bauteile angebracht. Die Halterung kann elektromotorisch abgesenkt werden, so daß die Bauteile gleichmäßig und mit gewünschtem Tempo in das GTM eingetaucht werden können. Die Wicklungen der Bauteile können mit einem geregelten Strom auf eine gewünschte Temperatur erwärmt werden.

Die Versuche wurden mit dem Stator eines kleinen Industriemotors mit einem Durchmesser von ca. 15 cm durchgeführt. Die Wicklungen sind in den Wickelköpfen über Hilfsrahmen aus Thermoplast geführt, weiter sind verschiedenfarbig mit Kunststoffen isolierte Anschlußdrähte vorhanden. Als GTM wurde das monomerfreie Harz Dobeckan MF 8001-UV der Firma Schenectady-Beck, Hamburg verwendet. Das Harz enthält Fotoinitiatoren.

### Beispiel 1 (B1) (Veraleichsbeispiel)

Bauteil und Tränkmittel haben Raumtemperatur von 26°C. Das Bauteile wird mit 135 mm/Min. eingetaucht, nach 1 Min. im Tränkmittel entweicht keine Luft mehr aus dem Bauteil. Jetzt wird die Wicklung auf 125°C erwärmt und 4 Minuten dabei gehalten. Dann wird ausgetaucht, 10 Min. über dem Tauchbad abtropfen gelassen, und die Wicklungsheizung auf 180°C erhöht und 20 Min. dabei gehalten. Dabei werden an der Oberfläche des Bauteils Temperaturen von 90 bis 120°C erreicht.

Nach dem Abkühlen ist die Oberfläche des Bauteils mit Ausnahme der Wicklungsdrähte mittel bis stark klebrig, auf den Thermoplastteilen und den Anschlußkabeln wirkt das Harz wenig bis überhaupt nicht gehärtet. Das Bauteil wird erst nach einer Nachhärtung von 4 Std. bei 130°C im Ofen brauchbar, obwohl auch schon vor dieser Ofenhärtung die Wicklungspakete gut gehärtet sind. Die Ofentemperatur darf ca. 130°C nicht übersteigen, um eine Deformation der Thermoplastteile zu vermeiden.

### Beispiel2 (B2) (Vergteichsbeispiel)

Es wird wie bei Beispiel 1 verfahren, aber nach der Wärmehärtung bei 180°C in 20 Min. für 10 Min. von unten und oben mit je 2 UV-Quecksilber-Mitteldruckstrahlen mit einer Leistungsaufnahme von je 500 W für 10 Min. bestrahlt. Dabei wird die Wicklungsheizung beibehalten, an der Oberfläche des Bauteils werden Temperaturen von 100-140°C erreicht. Das Bauteil ist in den Wicklungen und auf dem Blechpaket gut gehärtet, die Thermoplastteile und die Anschlußkabel sind noch leicht klebrig, zur Entklebung muß ca. 1 Std. bei 130°C im Ofen nachgehärtet werden.

### Beispiel 3 (B3)

Das GTM ist das gleiche (Dobeckan MF 8001) wie in den vorherigen Beispielen in einer Sondereinstellung ohne Fotoinitiator. Es wird wie bei Beispiel 1 verfahren, aber die Wärmehärtung mit Wicklungsheizung auf 8 Min. bei 180°C reduziert und dann von unten und oben mit je 2 geregelten NIR-Quellen mit einem Emissionsmaximum zwischen 750 nm und 1300 nm und einer Leistungsaufnahme von je ca. 2000 W für 40 s bestrahlt. Die Strahler werden über Thyristoren geregelt, die ein Regelsignal über Sensoren erhalten, welche die Oberflächentemperatur des Bauteils messen. Vorgegebene Ansteuertemperatur war 170°C. Es wird die Wicklungsheizung beibehalten, an der Oberfläche des Bauteils werden Temperaturen von 170-180°C erreicht.

Das Bauteil ist an der Oberfläche, auch an den Anschlußdrähten und am Thermoplastteil völlig klebfrei und im Innern gut gehärtet. Die Thermoplastteile zeigen keine Deformation oder sonstige Beschädigung.

### Beispiel 4 (B4) (Veraleichsbeispiel)

Es wurde wie bei Beispiel 3 verfahren, aber anstelle der NIR-Strahler waren langwellige IR-Stahler mit einem Emissionsmaximum bei ca. 7000 nm (Porzellandunkelstrahler) und einer Leistung von ebenfalls 2000 W montiert. Diese Strahler benötigen eine Anheizzeit von ca. 15 Min. bis zum Erreichen ihrer Leistung. Wurden diese Strahler vorgeheizt und dann über dem Bauteil positioniert, so kam es nach ca. 20 s zu oberflächlichen Verkohlungen der Tränkharze, ohne daß tieferliegende Bereiche gehärtet waren. Wurde die Leistung der Strahler über eine Spannungsregelung reduziert, so daß keine Verkohlungen mehr auftraten und Oberflächentemperaturen von ca. 200°C erreicht wurden, war eine ausreichende Härtung in die tieferliegenden Bereiche des Tränkmittels erst nach ca. 30 Min. erreicht.

Die Beispiele zeigen die erfindungsgemäßen Vorteile der Verwendung von NIR-Licht bei der Härtung von Elektroisoliermassen durch die Einsparungen an Fotoinitiator, Taktzeit und Energie. NIR-Strahlung ermöglicht eine sehr schnelle Härtung der Bauteiloberfläche mit guter Härtung auch dicker Schichten in die Tiefe dieser Schichten mit rein thermisch härtbaren Tränkmitteln. Dadurch werden die bekannten kostengünstigen, rein thermisch härtbaren Tränkmittel für schnelle Taktprozesse verwendbar ohne die Notwendigkeit, z.B. UVhärtbare Tränkmittel zu entwickeln oder teuere Fotoinitiatoren einzusetzen.

## Patentansprüche

1. Verfahren zur Isolierung elektrotechnischer Bauteile, bei welchem eine Schicht aus polymerisierbarem Gieß- und Tränkmittel und/oder Lack in fließfähiger Form auf die Oberfläche der Bauteile, aufgebracht, wobei eine Tränkung der Bauteile durch Tauchen, Fluten, Vakuumtränken, Vakuumdrucktränken oder Träufeln erfolgt, und anschließend mit energiereicher Strahlung ausgehärtet wird, **dadurch gekennzeichnet, daß** die energiereiche Strahlung Nah-Infra-Rot (NIR) Strahlung ist, die eine Wellenlänge von 500 nm bis 1400 nm hat, und wobei die Bauteile Transformatoren oder andere Bauteile mit Wicklungen sowie Leitungsdrähte sind.

2. Verfahren nach Anspruch 1, **dadurch gekennzeichnet, daß** die NIR Strahlung eine Wellenlänge von 750 nm bis 1100 nm hat.

3. Verfahren nach einem der Ansprüche 1 oder 2, **dadurch gekennzeichnet, daß** das Intensitätsmaximum der NIR Strahlung in einem Wellenlängenbereich liegt, bei dem das Gieß- und Tränkmittel bzw. der Lack einen Absoptionsgrad zwischen 20 und 80% hat.

4. Verfahren nach einem der Ansprüche 1 bis 3, **dadurch gekennzeichnet, daß** die NIR-Strahtung so fokussiert wird, daß in den zu härtenden Schichten eine der Härtungscharakteristik des Beschichtüngsmittels angepaßte Temperaturverteilung erreicht wird.

5. Verfahren nach einem der Ansprüche 1 bis 4, **dadurch gekennzeichnet, daß** die Bauteile bei Umgebungstemperatur oder im vorerwärmtem Zustand getränkt oder beim Tränken erwärmt werden.

6. Verfahren nach Anspruch 5, **dadurch gekennzeichnet, daß** die Bauteile nach dem Tränken und vor dem Härten bis zum Angelieren erwärmt werden.

7. Verfahren nach einem der Ansprüche 1 bis 6, **dadurch gekennzeichnet, daß** elektrisch leitende Wicklungen der durchgetränkten Bauteile im Tränkmittel durch Anlegen von Strom soweit erhitzt werden, daß eine gewünschte Tränkmittelmenge geliert und fixiert wird, daß nach dieser Gelierung das Bauteil aus dem Tränkmittel entnommen wird, ungeliertes Tränkmittel abläuft und daß die Bauteile danach ausgehärtet werden.

## Claims

1. Process for insulating electrical components involving applying a coat of polymerizable casting and impregnating composition and/or lacquer in flowable form to the surface of the components, the impregnation of the components taking place by immersion, flooding, vacuum impregnation, vacuum pressure impregnation or trickling, and then curing the coat with high-energy radiation, **characterized in that** the high-energy radiation is near-infrared (NIR) radiation having a wavelength of from 500 nm to 1400 nm, and the components being transformers or other components with windings, and also conducting wires.

2. Process as claimed in Claim 1, **characterized in that** the NIR radiation has a wavelength of from 750 nm to 1100 nm.

3. Process as claimed in one of Claims 1 or 2, **characterized in that** the intensity maximum of the NIR radiation is situated within a wavelength range wherein the casting and impregnating composition or lacquer has an absorbance of between 20 and 80%.

4. Process as claimed in one of Claims 1 to 3, **characterized in that** the NIR radiation is focused so that within the coats to be cured a temperature distribution adapted to the curing characteristics of the coating composition is achieved.

5. Process as claimed in one of Claims 1 to 4, **characterized in that** the components are impregnated at ambient temperature or in a preheated state or are heated during impregnation.

6. Process as claimed in Claim 5, **characterized in that**, following impregnation and before curing, the components are heated to the stage of partial gelling.

7. Process as claimed in one of Claims 1 to 6, **characterized in that** electrically conducting windings of the impregnated components are heated in the impregnating composition, by application of current, to an extent such that a desired amount of impregnating composition is gelled and fixed, **in that** after this gelling the component is removed from the impregnating composition, ungelled impregnating composition runs off, and **in that** the components are subsequently cured to completion.

## Revendications

1. Procédé d'isolation de composants électrotechniques, dans lequel une couche d'agent polymérisable de coulée et d'imprégnation et/ou de peinture est appliquée sous forme fluide à la surface des composants, l'imprégnation des composants s'effectuant par immersion, recouvrement, imprégnation sous vide, imprégnation sous vide et sous pression ou instillation, et est ensuite durcie par un rayonnement à haute énergie, **caractérisé en ce que** le rayonnement à haute en énergie est un rayonnement dans l'infrarouge proche (NIR) dont la longueur d'onde est comprise entre 500 nm et 1400 nm, les composants étant des transformateurs ou d'autres composants dotés d'enroulements ainsi que de fils conducteurs.

2. Procédé selon la revendication 1, **caractérisé en ce que** le rayonnement NIR a une longueur d'onde comprise entre 750 nm et 1100 nm.

3. Procédé selon l'une des revendications 1 ou 2, **caractérisé en ce que** le maximum d'intensité du rayonnement NIR est situé dans une plage de longueurs d'onde à laquelle l'agent de coulée et d'imprégnation ou la peinture ont un degré d'absorption compris entre 20 et 80 %.

4. Procédé selon l'une des revendications 1 à 3, **caractérisé en ce que** le rayonnement NIR est focalisé de telle sorte que dans les couches à durcir, on obtienne une répartition de température adaptée à la caractéristique de durcissement de l'agent de revêtement.

5. Procédé selon l'une des revendications 1 à 4, **caractérisé en ce que** les composants sont imprégnés à température ambiante ou à l'état préchauffé ou sont chauffés pendant l'imprégnation.

6. Procédé selon la revendication 5, **caractérisé en ce qu'**après l'imprégnation ou avant l'imprégnation, les composants sont chauffés jusqu'à gélifier.

7. Procédé selon l'une des revendications 1 à 6, **caractérisé en ce que** par application d'un courant, les enroulements électriquement conducteurs des composants imprégnés sont chauffés dans l'agent d'imprégnation suffisamment pour qu'une quantité souhaitée d'agent d'imprégnation gélifie et soit fixée et **en ce qu'**après cette gélification, le composant est enlevé de l'agent d'imprégnation, l'agent d'imprégnation non gélifié s'écoule et les composants sont ensuite durcis à coeur.
